# EUROPÄISCHE PATENTSCHRIFT

(11) **EP 2 999 119 B1**
(45) Veröffentlichungstag und Bekanntmachung des Hinweises auf die Patenterteilung: **06.06.2018**
(21) Anmeldenummer: 15182935.5
(22) Anmeldetag: 28.08.2015
(51) Int. Cl.: H03K 17/785

(54) **ELEKTRONISCHE STEUERUNGSKOMPONENTE, STEUERMODUL MIT DER ELEKTRONISCHEN STEUERUNGSKOMPONENTE, STELLGLIEDEINRICHTUNG MIT DEM STEUERMODUL SOWIE SCHRANKE MIT EINER SOLCHEN STELLGLIEDEINRICHTUNG**
ELECTRONIC CONTROLLER COMPONENT, CONTROL MODULE WITH THE ELECTRONIC CONTROL COMPONENT, POSITIONING DEVICE WITH THE CONTROL MODULE AND BARRIER WITH SUCH A POSITIONING DEVICE
COMPOSANT DE COMMANDE ELECTRONIQUE, MODULE DE COMMANDE DOTE D'UN COMPOSANT DE COMMANDE ELECTRONIQUE, DISPOSITIF D'ACTIONNEUR DOTE DU MODULE DE COMMANDE ET ARMOIRE COMPRENANT UN TEL DISPOSITIF D'ACTIONNEUR

(30) Priorität: 29.08.2014 DE 102014112511
(43) Veröffentlichungstag der Anmeldung: 23.03.2016
(73) Patentinhaber: PINTSCH BAMAG Antriebs- und Verkehrstechnik GmbH, 46537 Dinslaken (DE)
(72) Erfinder: ULMER, Helmut, 46499 Hamminkeln (DE)
(74) Vertreter: CBDL Patentanwälte

(56) Entgegenhaltungen:
- CA-A1- 2 105 041
- DE-A1- 3 519 252
- DE-T2- 3 779 789
- Toshiba: "Datasheet of TC4S584F Schmitt Trigger", , 7. April 1997 (1997-04-07), Seiten 1-4, XP055241276, INTERNET Gefunden im Internet: URL:http://pdf.datasheetcatalog.com/datash eets2/18/187294_1.pdf [gefunden am 2016-01-14]

## Beschreibung

### TECHNISCHES GEBIET DER ERFINDUNG

Die Erfindung betrifft das technische Gebiet der Schranken und deren Steuerungskomponenten. Insbesondere betrifft die Erfindung eine elektronische Steuerungskomponente, ein Steuermodul mit der elektronischen Steuerungskomponente, eine Stellgliedeinrichtung mit dem Steuermodul sowie Schranke mit einer solchen Stellgliedeinrichtung.

### HINTERGRUND DER ERFINDUNG

Auf dem Gebiet der Erfindung sind Schrankenantriebe mit einer Stellgliedmotoreinrichtungen wie jenen der Typen SPK 6-6 und SPK 10-10 der PINTSCH BAMAG Antriebs- und Verkehrstechnik GmbH, Dinslaken, Deutschland, bekannt. Solche Stellgliedmotoreinrichtungen besitzen jeweils einen Schrankenmotor, der über eine Vollbrücke je nach Ansteuerung der Vollbrücke vorwärts oder rückwärts angeschaltet wird. Zum Öffnen oder Schließen der Schranke werden jeweils ein Highside-Schalter zur Herstellung einer Verbindung zwischen einem Anschlusspol des Schrankenmotors und einem Batteriepluspol und ein Lowside-Schalter zur Herstellung einer Verbindung zwischen einem weiteren Anschlusspol des Schrankenmotors und einem Batterieminuspol verwendet. Dazu sind die Schalter über Treiber steuerbar und können mit einer softwarebasierten Steuerung verbunden sein. Dies birgt allerdings das Risiko von Softwarefehlern oder Fehlreaktionen in sich.

Bei Schranken von Bahnübergangsanlagen oder ähnlichen Anlagen ist aus Sicherheitsgründen eine zweite Schließfunktion bzw. ein sog. Ersatzschließen gefordert. Dazu kann ein Haltemagnet eingesetzt werden, wobei die Steuerung einer Bestromung des Haltemagnets über einen Signaltreiber und ein Schließen, d.h. das Ersatzschließen der Schranke, mit nicht bestromtem Haltemagnet vorgesehen ist. Die DE 36 36 104 A1 lehrt, dass in einem Relaiskanal ein durch die Signale dieses Kanals steuerbarer, einen Ausgang eines elektronischen Relais bildender Leistungsschalter vorgesehen werden kann, wobei die dem Ausgang des besagten Relaiskanals zugeführten Signale in logischer Abhängigkeit vom Schaltzustand des Leistungsschalters stehen, wobei als Leistungsschalter ein optisch steuerbarer Nullspannungsschalter vorgesehen ist, dessen Steuereingang mittelbar über einen Optokoppler mit einem Relaiseingang verbunden ist, wobei in eine zum Nullspannungsschalter führende Speiseleitung ein Stromwandler mit nachgeordneter Gleichrichterschaltung als Relaisausgang und mit einer über den Nullspannungsschalter durchgeschalteter Energieversorgung eingefügt ist. Gemäß der Lehre der CA 2 105 041 A1 speist ein Steuerstrom den Eingang eines Optokopplers, und ein Frequenzbegrenzungswiderstand ist mit einem Emitter und auch mit dem negativen Anschluss und ein Kollektor mit dem positiven Anschluss einer Diodenbrücke verbunden, bei der Wechselstromsignaleingänge parallel mit einem zwischen dem Eingang und dem Ausgang eines Schmitt-Triggers vorgesehenen Zeitgeber-Kondensator angeschlossen sind.

Die DE 35 19 252 A1 zeigt fehlersichere Logikschaltungen, bei denen wenigstens ein Signaleingang mit dem Signalausgang über Optokoppler verknüpft ist.

### OFFENBARUNG DER ERFINDUNG

Der Erfindung liegt die Aufgabe zugrunde, die Betriebssicherheit bei Schranken weiter zu erhöhen. Insbesondere soll sichergestellt werden, dass eine Schranke beim Ersatzschließen nicht durch einen Stellbefehl blockiert werden kann.

Zur Lösung der Aufgabe sieht die Erfindung eine elektronische Steuerungskomponente zwischen einem Pol und einem Gegenpol eines Potentials zur Ausgabe eines Taktsignals für einen oder für mehrere Signaltreiber vor, umfassend einen Taktgeber mit einem Versorgungsspannungsanschluss und zur Ausgabe des Taktsignals, einen ersten und einen zweiten Schalter, von denen jeder einen Stromanschluss und eine Funktion zum Aufbau einer elektrischen Verbindung bei einem durch den Stromanschluss fließenden Strom hat, wobei der Taktgeber mit seinem Versorgungsspannungsanschluss zwischen den Gegenpol und den ersten Schalter geschaltet ist, die Funktion zum Aufbau einer elektrischen Verbindung des ersten Schalters zum Anschluss des Taktgebers an den Pol vorgesehen ist, der erste Schalter mit seinem Stromanschluss zwischen einen ersten Signaleingang und den zweiten Schalter geschaltet ist, die Funktion zum Aufbau einer elektrischen Verbindung des zweiten Schalters zum Anschluss des Stromanschlusses des ersten Schalters an den genannten Gegenpol oder an einen von dem Gegenpol unabhängigen weiteren Gegenpol vorgesehen ist und der zweite Schalter mit seinem Stromanschluss zwischen den Pol und einen zweiten Signaleingang geschaltet ist. Der weitere Gegenpol ist ein Gegenpol zu dem ersten Signaleingang. Vorzugsweise ist die Funktion zum Aufbau einer elektrischen Verbindung des zweiten Schalters zum Anschluss des Stromanschlusses des ersten Schalters an diesen weiteren Gegenpol vorgesehen.

Bei dem ersten und/oder dem zweiten Schalter kann es sich jeweils um einen Optokoppler handeln, wobei der Stromanschluss des ersten bzw. zweiten Schalters dann ein Stromanschluss einer LED des Optokopplers ist.

Erfindungsgemäße elektronische Steuerungskomponenten können in einem Steuermodul verwendet werden, das neben einer solchen Steuerungskomponente auch einen Signaltreiber umfasst, wobei der Signaltreiber eine Ladungspumpe aufweist und ein Eingang des Signaltreibers mit dem Taktsignalausgang verbunden ist. Ein solches Steuermodul kann für eine Stellgliedeinrichtung für eine Schranke verwendet werden, wobei die Stellgliedeinrichtung das Steuermodul und ein Stellglied umfasst und eine Steuerung einer Bestromung des Stellglieds über den Signaltreiber vorgesehen ist.

Vorteilhafte Merkmale der Stellgliedeinrichtung sind in den Ansprüchen 11 bis 14 definiert. Bei der Stellgliedeinrichtung ist vorteilhaft eine Steuerung einer Bestromung des Stellglieds über den Signaltreiber vorgesehen, wobei das Stellglied insbesondere ein Elektromagnet als Haltemagnet für ein Ersatzschließen und/oder ein Schrankenmotor ist.

Vorteilhaft kann eine automatische Prüfung des Haltemagnets vor jedem Öffnen vorgesehen sein, bei der die Takterzeugung unterbrochen wird und dadurch die Funktionsfähigkeit geprüft wird.

Weitere Einzelheiten und Vorteile der Erfindung ergeben sich aus der nachfolgenden rein beispielhaften und nicht-beschränkenden Beschreibung von Ausführungsbeispielen in Verbindung mit der Zeichnung.

### KURZE BESCHREIBUNG DER ZEICHNUNG

- Fig. 1: zeigt schematisch eine Schaltungskomponente der Erfindung.
- Fig. 2: zeigt eine Ausführungsvariante der in Fig. 1 gezeigten Schaltungskomponente.

### BESCHREIBUNG BEVORZUGTER AUSFÜHRUNGSFORMEN

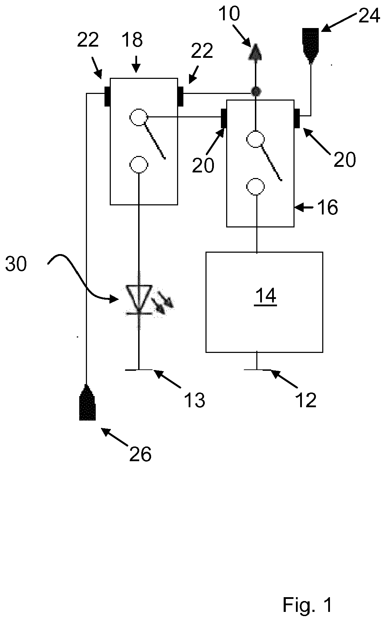

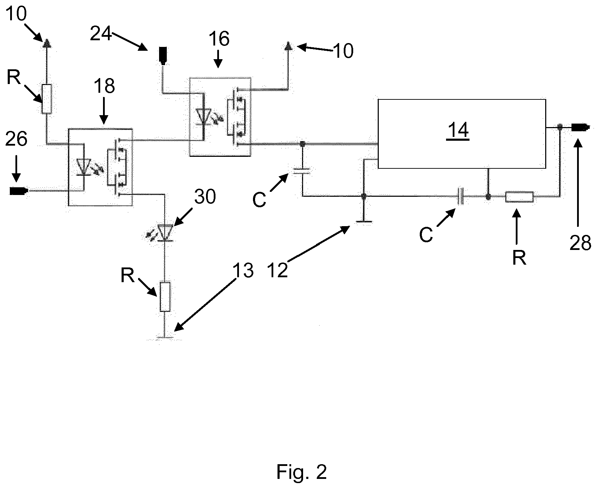

Wie in den Figuren 1 und 2 gezeigt, ist eine elektronische Steuerungskomponente zwischen einem Pol 10 und einem Gegenpol 12 eines Potentials zur Ausgabe eines Taktsignals für einen Signaltreiber vorgesehen.

Die elektronische Steuerungskomponente umfasst einen mit einem Versorgungsspannungsanschluss versehenen Taktgeber 14 zur Ausgabe des Taktsignals und einen ersten Schalter 16 und einen zweiten Schalter 18, von denen jeder einen Stromanschluss 20, 22 und eine Funktion zum Aufbau einer elektrischen Verbindung bei einem durch den Stromanschluss 20, 22 fließenden Strom besitzt.

Der Taktgeber 14 ist mit seinem Versorgungsspannungsanschluss zwischen den Gegenpol 12 und den ersten Schalter 16 geschaltet. Die Funktion zum Aufbau einer elektrischen Verbindung des ersten Schalters 16 ist zum Anschluss des Taktgebers 14 an den Pol 10 vorgesehen. Der erste Schalter 16 ist mit seinem Stromanschluss 20 zwischen einen ersten Signaleingang 24 und den zweiten Schalter geschaltet.

Die Funktion zum Aufbau einer elektrischen Verbindung des zweiten Schalters 18 ist zum Anschluss des Stromanschlusses 20 des ersten Schalters 16 an einen von dem Gegenpol 12 unabhängigen weiteren Gegenpol 13 vorgesehen. Der weitere Gegenpol 13 ist ein Gegenpol zu dem ersten Signaleingang 24. Der zweite Schalter 18 ist mit seinem Stromanschluss 22 zwischen den Pol 10 und einen zweiten Signaleingang 26 geschaltet.

Bei dem gezeigten Ausführungsbeispiel handelt es sich sowohl bei dem ersten Schalter 16 als auch bei dem zweiten Schalter 18 um jeweils einen Optokoppler, wobei bei jedem der Optokoppler der Stromanschluss 20, 22 ein Stromanschluss einer LED des Optokopplers ist.

Der Taktgeber 14 ist ein invertierender Schmitt-Trigger, insbesondere ein unter http://pdf.datasheetcatalog.com/datasheets2/18/187294_1.pdf gezeigter Schmitt-Trigger mit der Produktbezeichnung "TC4S584F" der Firma Toshiba.

Zwischen den Gegenpol 12 und einen Referenzspannungseingang des invertierenden Schmitt-Triggers ist ein Kondensator C geschaltet. Zwischen den Referenzspannungseingang und einen Taktsignalausgang 28 des invertierenden Schmitt-Triggers ist ein Widerstand R geschaltet. Zwischen den Gegenpol 12 und die Verbindung des ersten Optokopplers 16 zu dem Versorgungsspannungsanschluss des Taktgebers 14 ist ein Kondensator C geschaltet.

Der zweite Optokoppler 18 ist mit seinem Stromanschluss 22 über einen Widerstand R zwischen den Pol 10 und einen zweiten Signaleingang 26 geschaltet. Der zweite Optokoppler 18 ist für die Funktion zum Aufbau einer elektrischen Verbindung des zweiten Optokopplers 18 zum Anschluss des Stromanschlusses 20 des ersten Optokoppler 16 an den weiteren Gegenpol 13 über eine Kontroll-LED 30 an den weiteren Gegenpol 13 angeschlossen. Dabei ist die Kontroll-LED 30 über einen Widerstand R mit dem weiteren Gegenpol 13 verbunden.

Der Pol 10 ist als Batteriepluspol vorgesehen, wobei für den Gegenpol ein Potential von 0 Volt vorgesehen ist.

Ein in den Zeichnungen nicht dargestelltes erfindungsgemäßes Steuermodul umfasst die in Fig. 2 veranschaulichte elektronische Steuerungskomponente und einen Signaltreiber, wobei der Signaltreiber eine Ladungspumpe aufweist und ein Eingang des Signaltreibers mit dem Taktsignalausgang 28 verbunden ist. Eine Stellgliedeinrichtung für eine Schranke umfasst dieses Steuermodul und einen Haltemagnet und einen Schrankenmotor, für die eine Bestromung vorgesehen ist. Wie nachfolgend dargestellt, dient die Bestromung sowohl als Bestromung eines als Haltemagnet vorgesehenen Elektromagneten als auch als Bestromung des Motors der Schranke, um ein sicheres Ersatzschließen zu erlauben.

Bei der Stellgliedeinrichtung ist mit der in Fig. 2 veranschaulichten elektronischen Steuerungskomponente eine Funktion zur Haltemagnetprüfung vor jedem Öffnen der Schranke vorgesehen, bei der ist eine Takterzeugung mit dem Taktgeber bzw. Schmitt-Trigger 14 unterbrochen wird und eine Funktionsfähigkeitsprüfung erfolgt. Dazu wird mit dem in Fig. 2 veranschaulichten Signaleingang 26 eine Unterbrechung der Bestromung der LED des Optokopplers 18 veranlasst, um die am Signaleingang 24 angeschlossene Optokoppler-LED nicht mehr zu bestromen. Damit wird dem Taktgeber bzw. Schmitt-Trigger 14 die Betriebsspannung genommen, um dessen Taktsignalerzeugung zu unterbrechen.

Die Stellgliedmotoreinrichtung umfasst einen Schrankenmotor, der über eine Vollbrücke je nach Ansteuerung der Vollbrücke Vorwärts oder Rückwärts angeschaltet wird. Zum Öffnen oder Schließen der Schranke werden jeweils ein Highside-Schalter für eine Verbindung zwischen einem Anschlusspol des Schrankenmotors zu einem Batteriepluspol und ein Lowside-Schalter für eine Verbindung zwischen einem weiteren Anschlusspol des Schrankenmotors zu einem Batterieminuspol verwendet.

Die Ansteuerung des Highside-Schalters und eines Schalters für den Haltemagneten erfolgt über Ladungspumpen von Signaltreibern, die zum Empfang eines Taktsignals mit dem Taktsignalausgang des Taktgebers bzw. Schmitt-Triggers 14 verbunden sind. Ohne Taktsignal des Schmitt-Triggers 14 kann dadurch keine Ansteuerung der Highside-Schalter und Schalters für den Haltemagnet erfolgen. Dabei sind insbesondere folgende Schaltungszustände vorgesehen:
- Grundstellung: Der Optokoppler 18, der bei diesem Ausführungsbeispiel ein PHOTO-MOS-Relais ist, wird bestromt. Mit einer Abschaltspannung von Signaleingang 24 wird der Optokoppler 16, bei dem es sich hier ebenfalls um ein PHOTO-MOS-Relais handelt, bestromt und die Kontroll-LED 30 leuchtet als "Not zu"-Anzeige. Die Betriebsspannung ist dann vom Pol 10 zu dem Versorgungsspannungsanschluss des Taktgebers bzw. Schmitt-Triggers 14 durchgeschaltet, und das Taktsignal ist vorhanden.
- Steuerbefehl Ersatzschließen: Mit dem in Fig. 2 veranschaulichten Signaleingang 26 wird eine Unterbrechung der Bestromung der LED des Optokopplers 18 veranlasst. Die LED des in Fig. 2 veranschaulichten Optokopplers 16 wird nicht mehr bestromt, die Kontroll-LED 30 bzw. "Not zu"-Anzeige ist dunkel. Die Betriebsspannung des Taktgebers bzw. Schmitt-Triggers 14 fehlt, und das Taktsignal kann nicht mehr erzeugt werden.
- Notschließen: Beim Notschließen fehlt die Abschaltspannung von 6 Volt. Die LED des Optokopplers 16 wird nicht mehr bestromt und die Kontroll-LED bzw. "Not zu"-Anzeige ist dunkel. Dem Taktgeber bzw. Schmitt-Triggers 14 fehlt Betriebsspannung und das Taktsignal kann nicht mehr erzeugt werden. Durch das fehlende Taktsignal bei dem Steuerbefehl Ersatzschließen oder bei Notschließen ist eine Ansteuerung der Highside-Schalter nicht mehr möglich. Der Anker und das Feld des Schrankenmotors können nicht mehr angeschaltet werden. Das gleiche gilt auch für den Haltemagneten. Der Haltemagnet fällt ab. Die Schranke schließt mit Ersatzschließen.

Wie in Fig. 2 veranschaulicht, ist der Taktgeber 14 mit seinem Versorgungsspannungsanschluss zwischen den Gegenpol 12 und den ersten Optokoppler 16 geschaltet. Der erste Optokoppler 16 ist mit seinem Strom- bzw. LED-Anschluss 20 zwischen einen ersten Signaleingang 24 und den zweiten Schalter geschaltet. Die Funktion zum Aufbau einer elektrischen Verbindung des ersten Optokopplers 16 dient dem Anschluss des Taktgebers 14 an den Pol 10. Die Funktion zum Aufbau einer elektrischen Verbindung des zweiten Optokopplers 18 dient dem Anschluss des Strom- bzw. LED-Anschlusses des ersten Optokopplers 16 an den weiteren Gegenpol 13. Der zweite Optokoppler 18 ist mit seinem Strom- bzw. LED-Anschluss 22 zwischen den Pol 10 und einen zweiten Signaleingang 26 geschaltet.

### BEZUGSZEICHENLISTE

- 10: Pol
- 12, 13: Gegenpole
- 14: Taktgeber
- 16: erster Schalter
- 18: zweiter Schalter
- 20: Stromanschluss des ersten Schalters
- 22: Stromanschluss des zweiten Schalters
- 24: Signaleingang
- 26: Signaleingang
- 28: Taktsignalausgang
- 30: Kontroll-LED
- C: Kondensator
- R: Widerstand

## Patentansprüche

1. Elektronische Steuerungskomponente zwischen einem Pol (10) und einem Gegenpol (12) eines Potentials zur Ausgabe eines Taktsignals für einen Signaltreiber, umfassend
- einen mit einem Versorgungsspannungsanschluss versehenen Taktgeber (14) zur Ausgabe des Taktsignals,
- einen ersten Schalter (16) und einen zweiten Schalter (18), von denen jeder einen Stromanschluss (20, 22) und eine Funktion zum Aufbau einer elektrischen Verbindung bei einem durch den jeweiligen Stromanschluss (20, 22) fließenden Strom aufweist,
wobei
- der erste Schalter (16) mit seinem Stromanschluss (20) zwischen einen ersten Signaleingang (24) und den zweiten Schalter geschaltet ist,
- die Funktion zum Aufbau einer elektrischen Verbindung des zweiten Schalters (18) zum Anschluss des Stromanschlusses (20) des ersten Schalters (16) an den besagten Gegenpol (12) oder an einen von dem Gegenpol unabhängigen weiteren Gegenpol (13) zu dem ersten Signaleingang (24) vorgesehen ist und
- der zweite Schalter (18) mit seinem Stromanschluss (22) zwischen den Pol (10) und einen zweiten Signaleingang (26) geschaltet ist,
**dadurch gekennzeichnet dass**
- der Taktgeber (14) mit seinem Versorgungsspannungsanschluss zwischen den Gegenpol (12) und den ersten Schalter (16) geschaltet ist und
- die Funktion zum Aufbau einer elektrischen Verbindung des ersten Schalters (16) zum Anschluss des Taktgebers (14) an den Pol (10) vorgesehen ist.

2. Elektronische Steuerungskomponente nach Anspruch 1, wobei die Funktion zum Aufbau einer elektrischen Verbindung des zweiten Schalters (18) zum Anschluss des Stromanschlusses (20) des ersten Schalters (16), eine Funktion zum Anschluss des Stromanschlusses (20) des ersten Schalters (16) an den besagten Gegenpol (12) ist.

3. Elektronische Steuerungskomponente nach Anspruch 1 oder 2, wobei der erste Schalter (16) und/oder der zweite Schalter (16, 18) jeweils ein Optokoppler ist und der Stromanschluss (20, 22) des ersten bzw. zweiten Schalters ein Stromanschluss einer LED des jeweiligen Optokopplers ist.

4. Elektronische Steuerungskomponente nach einem der Ansprüche 1 bis 3, wobei der Taktgeber (14) ein invertierender Schmitt-Trigger ist.

5. Elektronische Steuerungskomponente nach Anspruch 4, wobei
- ein Kondensator (C) zwischen den Gegenpol (12) und einen Referenzspannungseingang des invertierenden Schmitt-Triggers geschaltet ist und
- ein Widerstand (R) zwischen den Referenzspannungseingang und einen Taktsignalausgang (28) des invertierenden Schmitt-Triggers geschaltet ist.

6. Elektronische Steuerungskomponente nach einem der vorhergehenden Ansprüche, wobei ein Kondensator (C) zwischen den Gegenpol (12) und die Verbindung des ersten Schalters (16) zu dem Versorgungsspannungsanschluss des Taktgebers (14) geschaltet ist.

7. Elektronische Steuerungskomponente nach einem der vorhergehenden Ansprüche, wobei der zweite Schalter (18) mit seinem Stromanschluss (22) über einen Widerstand (R) zwischen den Pol (10) und einen zweiten Signaleingang (26) geschaltet ist.

8. Steuermodul, umfassend:
- eine elektronische Steuerungskomponente nach einem der vorhergehenden Ansprüche,
- einen Signaltreiber, wobei der Signaltreiber eine Ladungspumpe aufweist und ein Eingang des Signaltreibers mit dem Taktsignalausgang (28) verbunden ist.

9. Stellgliedeinrichtung für eine Schranke, umfassend ein Steuermodul nach Anspruch 8 und ein Stellglied, wobei eine Steuerung einer Bestromung des Stellglieds über den Signaltreiber vorgesehen ist.

10. Stellgliedeinrichtung nach Anspruch 9, umfassend einen Signalgeber mit einer Funktion zur Ausgabe einer Abschaltspannung an den ersten Signaleingang (24).

11. Stellgliedeinrichtung nach Anspruch 9 oder 10, umfassend einen Signalgeber mit einer Funktion zur Ausgabe eines Ersatzschließbefehls durch Unterbrechung einer Bestromung des Stromanschlusses (22) des zweiten Schalters (18) mit dem zweiten Signaleingang (26).

12. Stellgliedeinrichtung nach Anspruch 10 oder 11, wobei der zweite Schalter (18) für die Funktion zum Aufbau einer elektrischen Verbindung des zweiten Schalters (18) zum Anschluss des Stromanschlusses (20) des ersten Schalters (16) an den Gegenpol (12) oder an den weiteren Gegenpol (13) über eine Kontroll-LED (30) angeschlossen ist.

13. Stellgliedeinrichtung nach Anspruch 9, wobei das Stellglied ein als Haltemagnet vorgesehener Elektromagnet und/oder ein Motor der Schranke ist.

14. Schranke mit einer Stellgliedeinrichtung nach einem der Ansprüche 9 bis 13.

## Claims

1. Electronic controller component between a pole (10) and a counter-pole (12) of a potential for outputting a clock signal for a signal driver, comprising
- a clock generator (14) provided with a supply voltage connector for outputting the clock signal,
- a first switch (16) and a second switch (18), each of which having a power connector (20, 22) and a function for setting up an electrical connection when a current is flowing through the respective power connector (20, 22),
wherein
- the first switch (16) is switched with its power connector (20) between a first signal input (24) and the second switch,
- the function for setting up an electrical connection of the second switch (18) is provided for connecting the power connector (20) of the first switch (16) to the said counter-pole (12) or to a further counter-pole (13), which is independent of the opposite pole, to the first signal input (24), and
- the second switch (18) is switched with its power connector (22) between the pole (10) and a second signal input (26),
**characterized in that**
- the clock generator (14) is switched with its supply voltage connector between the opposite pole (12) and the first switch (16) and
- the function for setting up an electrical connection of the first switch (16) is provided for connecting the clock generator (14) to the pole (10).

2. Electronic controller component according to Claim 1, wherein the function for setting up an electrical connection of the second switch (18) for connecting the power connector (20) of the first switch (16) is a function for connecting the power connector (20) of the first switch (16) to the said counter-pole (12).

3. Electronic controller component according to Claim 1 or 2, wherein the first switch (16) and/or the second switch (16, 18) is/are optocoupler(s) and the power connector (20, 22) of the first or second switch is a power connector of an LED of the respective optocoupler.

4. Electronic controller component according to any one of Claims 1 to 3, wherein the clock generator (14) is an inverting Schmitt trigger.

5. Electronic controller component according to Claim 4, wherein
- a capacitor (C) is connected between the counter-pole (12) and a reference voltage input of the inverting Schmitt trigger and
- a resistor (R) is connected between the reference voltage input and a clock signal output (28) of the inverting Schmitt trigger.

6. Electronic controller component according to any one of the preceding claims, wherein a capacitor (C) is connected between the counter-pole (12) and the connection of the first switch (16) to the supply voltage connector of the clock generator (14).

7. Electronic controller component according to any one of the preceding claims, wherein the second switch (18) is switched with its power connector (22) via a resistor (R) between the pole (10) and a second signal input (26).

8. Control module, comprising:
- an electronic controller component according to any one of the preceding claims,
- a signal driver, wherein the signal driver has a charge pump and one input of the signal driver is connected to the clock signal output (28).

9. Actuator device for a barrier, comprising a control module according to Claim 8 and an actuator, wherein the control of a current supply of the actuator is provided via the signal driver.

10. Actuator device according to Claim 9, comprising a signal generator with a function for outputting a cut-off voltage to the first signal input (24).

11. Actuator device according to Claim 9 or 10, comprising a signal emitter with a function for outputting a substitute closing command by interruption of a current supply of the power connector (22) of the second switch (18) with the second signal input (26).

12. Actuator device according to Claim 10 or 11, wherein the second switch (18) for the function for setting up an electrical connection of the second switch (18) for connecting the power connector (20) of the first switch (16) to the counter-pole (12) or to the additional counter-pole (13) is connected via a control LED (30).

13. Actuator device according to Claim 9, wherein the actuator is an electromagnet, provided as a holding magnet, and/or a motor of the barrier.

14. Barrier having an actuator device according to any one of claims 9 to 13.

## Revendications

1. Composant de commande électronique entre un pôle (10) et un pôle opposé (12) d'un potentiel pour délivrer un signal d'horloge pour un circuit d'attaque de signaux, comprenant
- une horloge (14) pour délivrer le signal d'horloge, qui est pourvue d'un raccordement de tension d'alimentation,
- un premier interrupteur (16) et un deuxième interrupteur (18) dont chacun présente un raccordement électrique (20, 22) et une fonction d'établissement d'une connexion électrique dans le cas d'un courant circulant à travers le raccordement électrique (20, 22) respectif,
dans lequel
- ledit premier interrupteur (16) avec son raccordement électrique (20) est monté entre une première entrée de signal (24) et ledit deuxième interrupteur,
- la fonction d'établissement d'une connexion électrique du deuxième interrupteur (18) est prévue pour raccorder le raccordement électrique (20) du premier interrupteur (16) audit pôle opposé (12) ou à un autre pôle opposé (13) à la première entrée de signal (24) et indépendant dudit pôle opposé, et
- ledit deuxième interrupteur (18) avec son raccordement électrique (22) est monté entre le pôle (10) et une deuxième entrée de signal (26),
**caractérisé en ce que**
- ladite horloge (14) avec son raccordement de tension d'alimentation est montée entre ledit pôle opposé (12) et le premier interrupteur (16), et
- la fonction d'établissement d'une connexion électrique du premier interrupteur (16) est prévue pour raccorder l'horloge (14) au pôle (10).

2. Composant de commande électronique selon la revendication 1, dans lequel la fonction d'établissement d'une connexion électrique du deuxième interrupteur (18) pour raccorder le raccordement électrique (20) du premier interrupteur (16) est une fonction pour raccorder le raccordement électrique (20) du premier interrupteur (16) audit pôle opposé (12).

3. Composant de commande électronique selon la revendication 1 ou 2, dans lequel le premier interrupteur (16) et/ou le deuxième interrupteur (16, 18) est respectivement un optocoupleur, et le raccordement électrique (20, 22) du premier ou bien du deuxième interrupteur est un raccordement électrique d'une DEL de l'optocoupleur respectif.

4. Composant de commande électronique selon l'une quelconque des revendications 1 à 3, dans lequel l'horloge (14) est un trigger de Schmitt inverseur.

5. Composant de commande électronique selon la revendication 4, dans lequel
- un condensateur (C) est monté entre le pôle opposé (12) et une entrée de tension de référence du trigger de Schmitt inverseur, et
- une résistance (R) est montée entre ladite entrée de tension de référence et une sortie de signal d'horloge (28) du trigger de Schmitt inverseur.

6. Composant de commande électronique selon l'une quelconque des revendications précédentes, dans lequel un condensateur (C) est monté entre le pôle opposé (12) et la liaison du premier interrupteur (16) au raccordement de tension d'alimentation de l'horloge (14).

7. Composant de commande électronique selon l'une quelconque des revendications précédentes, dans lequel le deuxième interrupteur (18) avec son raccordement électrique (22) est monté par une résistance (R) entre le pôle (10) et une deuxième entrée de signal (26).

8. Module de commande comprenant:
- un composant de commande électronique selon l'une quelconque des revendications précédentes,
- un circuit d'attaque de signaux, dans lequel ledit circuit d'attaque de signaux présente une pompe de charge, et une entrée du circuit d'attaque de signaux est reliée à la sortie de signal d'horloge (28).

9. Dispositif actionneur pour une barrière, comprenant un module de commande selon la revendication 8 et un actionneur, dans lequel on prévoit une commande d'une alimentation en courant de l'actionneur via ledit circuit d'attaque de signaux.

10. Dispositif actionneur selon la revendication 9, comprenant un générateur de signaux ayant une fonction consistant à fournir une tension d'arrêt à la première entrée de signal (24).

11. Dispositif actionneur selon la revendication 9 ou 10, comprenant un générateur de signaux ayant une fonction consistant à fournir une instruction de fermeture de secours en interrompant une alimentation en courant du raccordement électrique (22) du deuxième interrupteur (18) avec la deuxième entrée de signal (26).

12. Dispositif actionneur selon la revendication 10 ou 11, dans lequel le deuxième interrupteur (18) pour la fonction d'établissement d'une connexion électrique du deuxième interrupteur (18) pour raccorder le raccordement électrique (20) du premier interrupteur (16) au pôle opposé (12) ou à l'autre pôle opposé (13) est connecté via une DEL de contrôle (30).

13. Dispositif actionneur selon la revendication 9, dans lequel l'actionneur est un électro-aimant prévu en tant qu'aimant de maintien et/ou un moteur de la barrière.

14. Barrière comprenant un dispositif actionneur selon l'une quelconque des revendications 9 à 13.
